# EUROPEAN PATENT APPLICATION

(11) **EP 1 953 830 A2**
(43) Date of publication of application: **06.08.2008**
(21) Application number: 07009131.9
(22) Date of filing: 07.05.2007
(51) Int. Cl.: H01L 31/052

(54) **An optical superposing solar power supply device**

(30) Priority: 29.01.2007 CN 200710008511
(71) Applicant: Wu, NG Shun, Fujian Province (CN)
(72) Inventor: Wu, NG Shun, Fujian Province (CN)
(74) Representative: Brown, James Douglas

(57) **Abstract**

The present invention provides an optical superposing solar power supply device, mainly comprising a solar cell and an accumulator. The solar cell mainly comprises an optical superposing mirror and a solar wafer. The optical superposing mirror is formed by at least one optical superposing mirror unit with an inclined plane or an inclined arc surface being linked together through welding, or is composed of an elliptic parabolic surface or a cone, and each reflected sunlight ray by the mirror is impinged on an irradiated surface of the solar wafer. The optical superposing mirror can reflect, concentrate and project a larger area of sunlight onto the solar wafer with a smaller area, increasing the utility efficiency of solar energy, and saving a cell plate with an expensive manufacturing cost compared with the prior art. Moreover, a cheap plastic electro-plating material, a cheap stainless steel plate, or a cheap mirror material can be used as the material of the optical superposing mirror unit, so that the cost of the optical superposing mirror unit is greatly reduced, which is more advantageous to extend its application in the market. The solar cell of the invention, in conjunction with a wind power generator, can provide an outdoor installation with a day and night power supply.

## Description

### Field of the Invention

The present invention relates to a solar power supply device.

### Background of the Art

Currently, it is known that a solar power generation device adopts a flat photovoltaic cell, which generates electric power by the natural irradiation of the sunlight. This method needs a big area of solar wafer to receive light energy. The cost of manufacturing the solar wafer is expensive, and its utility efficiency is low. The progress of the photovoltaic industry is affected by the high cost of the solar wafer.

### Summary of the Invention

In view of the disadvantages mentioned above in the prior art, the present invention is to provide a low-cost and easily manufactured solar power supply device, wherein a solar wafer is inversely suspended in the air, under which an optical superposing mirror for reflecting the sunlight is disposed. The optical superposing mirror is capable of increasing the irradiation intensity of the sunlight received by a solar cell, so the efficiency of the solar cell is increased to up to 400%. A number of identical devices can also be combined to adapt them to large-scale, medium-scale or small-scale solar power supply devices, and the lifetime of the wafer is long, which is advantageous to extend application of the photovoltaic power generation system all over the world.
To reach the object above mentioned, in a respect, the invention provides an optical superposing solar power supply device, mainly comprising a solar cell and an accumulator, characterized in that: the solar cell comprises a solar cell assembly, the solar cell assembly mainly comprises a solar wafer and a ring-shaped optical superposing mirror made of a reflective material, the ring-shaped optical superposing mirror is formed by at least one optical superposing mirror unit being linked together through welding to form a ring, and the optical superposing mirror unit is an inclined plane which is formed by an oblique line rotating larger than 0 degree but not larger than 180 degrees around the central axis of the ring-shaped optical superposing mirror, wherein, the solar wafer is disposed above the optical superposing mirror, with an irradiated surface thereof disposed downward, and each reflected sunlight ray by the inclined plane is impinged on the irradiated surface of the solar wafer.

In another respect, the invention provides an optical superposing solar power supply device, mainly comprising a solar cell and an accumulator, characterized in that: the solar cell comprises a solar cell assembly, the solar cell assembly mainly comprises a solar wafer and a ring-shaped optical superposing mirror made of a reflective material, the ring-shaped optical superposing mirror is formed by at least one optical superposing mirror unit being linked together through welding to form a ring, and the optical superposing mirror unit is an inclined arc surface which is formed by an arc line rotating larger than 0 degree but not larger than 180 degrees around the central axis of the ring-shaped optical superposing mirror, wherein, the solar wafer is disposed above the optical superposing mirror, with an irradiated surface thereof disposed downward, and each reflected sunlight ray by the inclined arc surface is impinged on the irradiated surface of the solar wafer. In a still another respect, the invention provides an optical superposing solar power supply device, mainly comprising a solar cell and an accumulator, characterized in that: the solar cell comprises a solar cell assembly, the solar cell assembly mainly comprises a solar wafer and an optical superposing mirror made of a reflective material, and the optical superposing mirror is an elliptic parabolic surface with a recessed portion, the recessed portion being provided with a through hole, wherein, the solar wafer is disposed above the optical superposing mirror, with an irradiated surface thereof disposed downward, and each reflected sunlight ray by the parabolic surface is impinged on the irradiated surface of the solar wafer.

In a yet another respect, the invention provides an optical superposing solar power supply device, mainly comprising a solar cell and an accumulator, characterized in that: the solar cell comprises a solar cell assembly, the solar cell assembly mainly comprises a solar wafer and an optical superposing mirror made of a reflective material, and the optical superposing mirror is a cone with a recessed portion, the recessed portion being provided with a through hole, wherein, the solar wafer is disposed above the optical superposing mirror, with an irradiated surface thereof disposed downward, and each reflected sunlight ray by an parabolic surface of the cone Is impinged on the irradiated surface of the solar wafer.

A protective box is disposed outside the solar wafer.

The reflective material is a plastic electro-plating material, a stainless steel plate, or a reflective mirror material.

The optical superposing solar power supply device is composed of at least one solar cell assembly.

The advantages of the present invention are as follows. An optical superposing mirror is formed by at least one optical superposing mirror unit with an inclined plane or an inclined arc surface being linked together through welding, or is composed of an elliptic parabolic surface or a cone, and each reflected sunlight ray by the mirror is impinged on an irradiated surface of the solar wafer. The optical superposing mirror can reflect, concentrate and project a larger area of sunlight onto a solar wafer with a smaller area, increasing the utility efficiency of solar energy, and saving a cell plate with an expensive manufacturing cost compared with the prior art. Moreover, a cheap plastic electro-plating material, a cheap stainless steel plate, or a cheap mirror material can be used as the material of the optical superposing mirror unit, so that the cost of the optical superposing mirror unit is greatly reduced, which is more advantageous to extend its application in the market. The irradiated surface of the solar wafer is disposed downward, and a protective cover is disposed outside the solar wafer, which prevents a variety of contaminants such as the dust and bird droppings from building up on the irradiated surface. The optical superposing mirror is designed to be ring or hollow, reducing the air resistance to easily discharge water and lengthen the lifetime of the solar wafer. The solar cell of the invention, in conjunction with a wind power generator, can provide an outdoor installation with a day and night power supply.

### Brief Description of the Drawings

FIG. 1 is a diagram of an optical superposing solar power supply device of an embodiment of the present invention working in place;
FIG. 2 is a perspective view of the structure of an optical superposing solar power supply device according to the first embodiment of the present invention;
FIG. 3 is a front view of the structure of an optical superposing solar power supply device according to the first embodiment of the present invention;
FIG. 4 is a top view of the structure of an optical superposing solar power supply device according to the second embodiment of the present invention;
FIG. 5 is a front view of the structure of an optical superposing solar power supply device according to the third embodiment of the present invention;
FIG. 6 is a perspective view of the structure of an optical superposing solar power supply device according to the fourth embodiment of the present invention;
FIG. 7 is a front view of the structure of an optical superposing solar power supply device according to the fourth embodiment of the present invention;
FIG. 8 is a diagram showing the principle of optical reflection in optical superposing solar power supply devices according to the second and fourth embodiments of the present invention.

### Detailed Description of the Invention

The present invention is now described by the following embodiments In connection with the drawings.

### Embodiment One

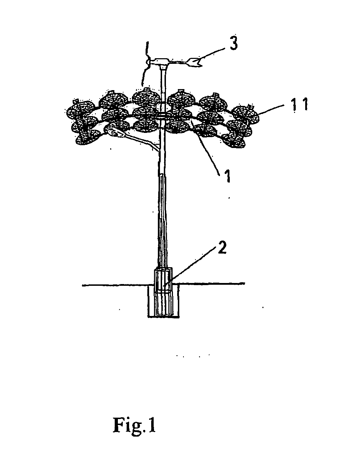

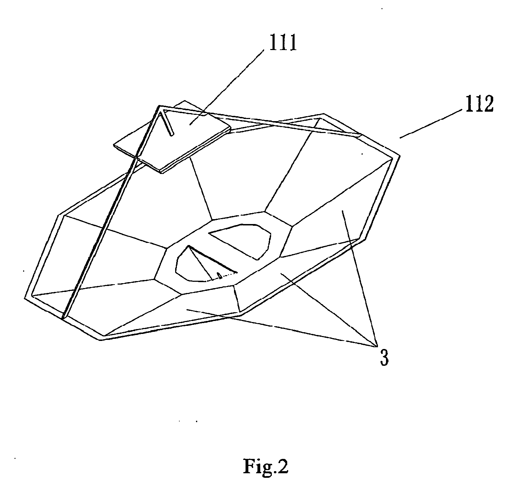

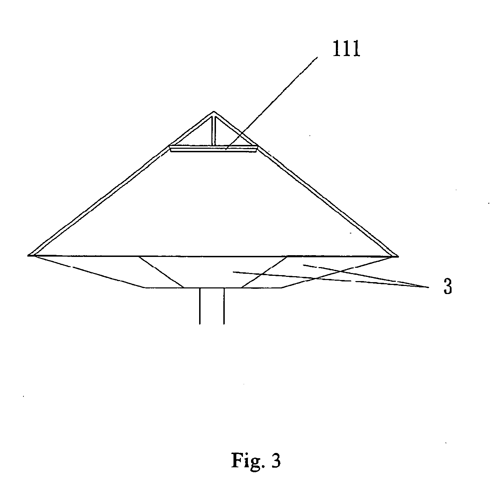

An optical superposing solar power supply device as shown in FIGS. 1, 2 and 3 mainly comprises at least a solar cell 1 and an accumulator 2, and the solar cell 1 comprises at least one solar cell assembly. The solar cell assembly mainly comprises a solar wafer 111 and a ring-shaped optical superposing mirror 112 made of a reflective material, the ring-shaped optical superposing mirror 112 is formed by more than two optical superposing mirror units 3 being linked together through welding to form a ring, the optical superposing mirror unit 3 is a inclined plane which is formed by an oblique line rotating larger than 0 degree but not larger than 180 degrees around the central axis of the ring-shaped optical superposing mirror 112, the solar wafer 111 is disposed above the optical superposing mirror 112, with an irradiated surface thereof disposed downward, and each reflected sunlight ray by the inclined plane is impinged on the irradiated surface of the solar wafer 111. Eight optical superposing mirror units 3 are used in the embodiment of the present invention, and each of optical superposing mirror units 3 is formed by an oblique line rotating 45 degrees around the central axis of the ring-shaped optical superposing mirror 112, so the optical superposing mirror 112 takes on a hollow "Eight Trigrams" type with a small space occupation. When two optical superposing mirror units 3 are used, each of optical superposing mirror units 3 is formed by an oblique line rotating 180 degrees around the central axis of the ring-shaped optical superposing mirror 112. Thus, the number of optical superposing mirror units as used can increased or decreased in accordance with the season, latitude and longitude, as well as the irradiation intensity of sunlight in different places, to adapt them to various types of solar power supply devices with different scales. Where the irradiation intensity of sunlight is very weak, the number of the mirrors can be increased arbitrarily.

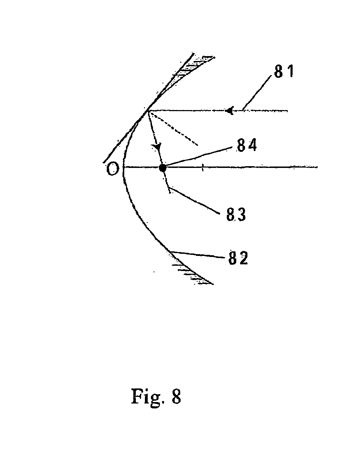

The principle of optical reflection of sunlight on an ac surface is shown in FIG. 8. Any one ray 81 parallel to a symmetric axis is incident onto an arc surface 82, and then is reflected by the arc surface. The reflected ray 83 must pass through the focus 84 of arc lines. Through multi-reflections of sunlight on the arc surface 82, reflected sunlight is superposed together so that there is no shadow, so ensuring the solar wafer to receive sunlight uniformly.

### Embodiment Two

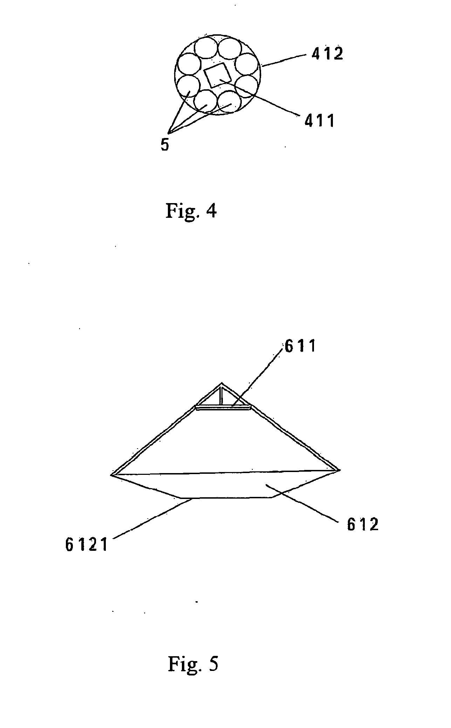

An optical superposing solar power supply device as shown in FIG. 4 mainly comprises at least a solar cell 1 and an accumulator 2, and the solar cell 1 comprises at least one solar cell assembly. The solar cell assembly mainly comprises a solar wafer 411 and a ring-shaped optical superposing mirror 412 made of a reflective material, the ring-shaped optical superposing mirror 412 is formed by at least one optical superposing mirror units 5 being linked together through welding to form a ring, the optical superposing mirror unit 5 is a inclined arc surface which is formed by an arc line rotating larger than 0 degree but not larger than 180 degrees around the central axis of the ring-shaped optical superposing mirror 412. The solar wafer 411 is disposed above the optical superposing mirror 412, with an irradiated surface thereof disposed downward, and each reflected sunlight ray by the inclined arc surface is impinged on the irradiated surface of the solar wafer 411. Eight optical superposing mirror units 5 are used in the embodiment of the present invention, and each of optical superposing mirror units 5 is formed by an arc line rotating 45 degrees around the central axis of the ring-shaped optical superposing mirror 412, so the optical superposing mirror 412 takes on a hollow "Eight Trigrams" type with a small space occupation. When two optical superposing mirror units 5 are used, each of optical superposing mirror units 5 is formed by an arc line rotating 180 degrees around the central axis of the ring-shaped optical superposing mirror 412. Thus, the number of optical superposing mirror units as used can increased or decreased in accordance with the season, latitude and longitude, as well as the irradiation intensity of sunlight in different places, to adapt them to various types of solar power supply devices with different scales. Where the irradiation intensity of sunlight is very weak, the number of the mirrors can be increased arbitrarily.

### Embodiment Three

An optical superposing solar power supply device as shown in FIG. 5 mainly comprises a solar cell 1 and an accumulator 2, and the solar cell 1 comprises at least one solar cell assembly. The solar cell assembly mainly comprises a solar wafer 611 and an optical superposing mirror 612 made of a reflective material. The optical superposing mirror 612 is a cone with a recessed portion, the recessed portion being provided with a through hole 6121. The solar wafer 611 is disposed above the optical superposing mirror 612 with an irradiated surface thereof disposed downward, and the focus of arc lines on the cone lies on the irradiated surface of the solar wafer 611.

### Embodiment Four

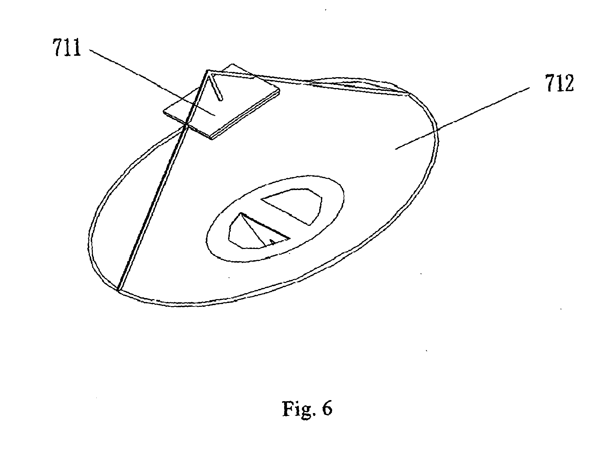

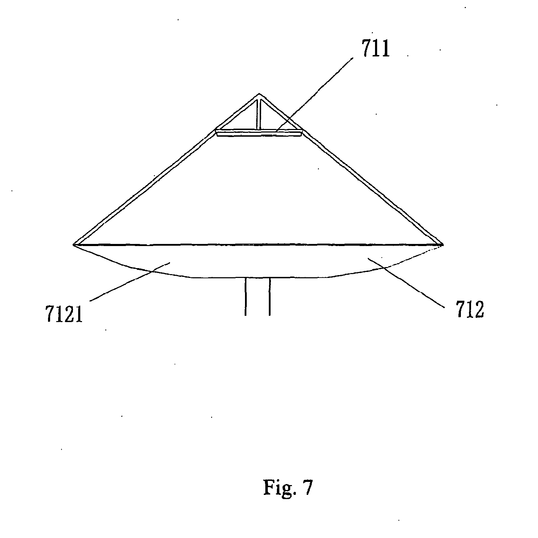

An optical superposing solar power supply device as shown in FIGS. 6 and 7 mainly comprises a solar cell 1 and an accumulator 2, and the solar cell 1 comprises at least one solar cell assembly. The solar cell assembly mainly comprises a solar wafer 711 and an optical superposing mirror 712 made of a reflective material. The optical superposing mirror 712 is an elliptic parabolic surface with a recessed portion, the recessed portion being provided with a through hole 7121. The solar wafer is disposed above the optical superposing mirror 712, with an irradiated surface thereof disposed downward, and the focus of arc lines on the parabolic surface lies on the irradiated surface of the solar wafer 711.

Accordingly, a ring-shaped optical superposing mirror is formed by at least one optical superposing mirror unit with an inclined plane or an oblique arc surface being linked together through welding, or is composed of an elliptic parabolic surface or a cone, and each reflected sunlight ray by the mirror is impinged on the irradiated surface of the solar wafer. The optical superposing mirror can reflect, concentrate and project a larger area of sunlight onto a solar wafer with a smaller area, increasing the utility efficiency of solar energy, and saving a cell plate with an expensive manufacturing cost compared with the prior art. Moreover, a cheap plastic electro-plating material, a cheap stainless steel plate, or a cheap mirror material can be used as the material of the optical superposing mirror unit, so that the cost of the optical superposing mirror unit is greatly reduced, which is more advantageous to extend its application in the market. An irradiated surface of the solar wafer is disposed downward, and a protective cover is disposed outside the solar wafer, which prevents a variety of contaminants such as the dust and bird droppings from building up on the irradiated surface. The optical superposing mirror is designed to be ring or hollow, reducing the air resistance to easily discharge water and lengthen the lifetime of the solar wafer. The solar cell of the invention, in conjunction with a wind power generator, can provide an outdoor installation with a day and night power supply.

## Claims

1. An optical superposing solar power supply device, comprising a solar cell and an accumulator, **characterized in that**: the solar cell comprises a solar cell assembly, the solar cell assembly comprises a solar wafer and a ring-shaped optical superposing mirror made of a reflective material, the ring-shaped optical superposing mirror is formed by at least one optical superposing mirror unit being linked together through welding to form a ring, and the optical superposing mirror unit is an inclined plane which is formed by an oblique line rotating larger than 0 degree but not larger than 180 degrees around the central axis of the ring-shaped optical superposing mirror, wherein, the solar wafer is disposed above the optical superposing mirror, with an irradiated surface thereof disposed downward, and each reflected sunlight ray by the inclined plane is impinged on the irradiated surface of the solar wafer.

2. An optical superposing solar power supply device, comprising a solar cell and an accumulator, **characterized in that**: the solar cell comprises a solar cell assembly, the solar cell assembly comprises a solar wafer and a ring-shaped optical superposing mirror made of a reflective material, the ring-shaped optical superposing mirror is formed by at least one optical superposing mirror unit being linked together through welding to form a ring, and the optical superposing mirror unit is an inclined arc surface which is formed by an arc line rotating larger than 0 degree but not larger than 180 degrees around the central axis of the ring-shaped optical superposing mirror, wherein, the solar wafer is disposed above the optical superposing mirror, with an irradiated surface thereof disposed downward, and each reflected sunlight ray by the inclined arc surface is Impinged on the irradiated surface of the solar wafer.

3. An optical superposing solar power supply device, comprising a solar cell and an accumulator, **characterized in that**: the solar cell comprises a solar cell assembly, the solar cell assembly comprises a solar wafer and an optical superposing mirror made of a reflective material, and the optical superposing mirror is an elliptic parabolic surface with a recessed portion, the recessed portion being provided with a through hole, wherein, the solar wafer is disposed above the optical superposing mirror, with an irradiated surface thereof disposed downward, and each reflected sunlight ray by the parabolic surface is impinged on the irradiated surface of the solar wafer.

4. An optical superposing solar power supply device, comprising a solar cell and an accumulator, **characterized in that**: the solar cell comprises a solar cell assembly, the solar cell assembly comprises a solar wafer and an optical superposing mirror made of a reflective material, and the optical superposing mirror is a cone with a recessed portion, the recessed portion being provided with a through hole, wherein, the solar wafer is disposed above the optical superposing mirror, with an irradiated surface thereof disposed downward, and each reflected sunlight ray by an parabolic surface of the cone is impinged on the irradiated surface of the solar wafer.

5. The optical superposing solar power supply device of any one of claims 1, 2, 3, and 4 **characterized in that**, a protective box is disposed outside the solar wafer.

6. The optical superposing solar power supply device of any one of claims 1, 2, 3, and 4 **characterized in that**, the reflective material is a plastic electro-plating material, a stainless steel plate, or a reflective mirror material.

7. The optical superposing solar power supply device of claim 5, **characterized in that**, the reflective material is a plastic electro-plating material, a stainless steel plate, or a reflective mirror material.

8. The optical superposing solar power supply device of any one of claims 1, 2, 3, and 4 **characterized in that**, the optical superposing solar power supply device is at least composed of at least one solar cell assembly.

9. The optical superposing solar power supply device of claim 5 **characterized in that**, the optical superposing solar power supply device is at least composed of at least one solar cell assembly.

10. The optical superposing solar power supply device of claim 6 **characterized in that**, the optical superposing solar power supply device is at least composed of at least one solar cell assembly.

11. The optical superposing solar power supply device of claim 7 **characterized in that**, the optical superposing solar power supply device is at least composed of at least one solar cell assembly.
